# EUROPEAN PATENT APPLICATION

(11) **EP 4 738 359 A1**
(43) Date of publication of application: **06.05.2026**
(21) Application number: 25208558.4
(22) Date of filing: 14.10.2025
(51) Int. Cl.: G11C 7/12, G11C 11/419

(54) **STATIC RANDOM ACCESS MEMORY DEVICE WITH PRE-CHARGE CIRCUIT SHARED BETWEEN DATA LINES AND BIT LINES**

(30) Priority: 29.10.2024 US 202463713062 P; 15.09.2025 US 202519328238
(71) Applicant: MEDIATEK INC., Hsinchu City 30078 (TW)
(72) Inventor: YANG, Tzu-Hsien, 30078 Hsinchu City (TW); CHIU, Yi-Te, 30078 Hsinchu City (TW)
(74) Representative: Hoefer & Partner Patentanwälte mbB

(57) **Abstract**

A memory device (100) includes a first static random access memory array (102), a first multiplexer circuit (110), and a pre-charge circuit (112). The first static random access memory array (102) includes a plurality of first static random access memory cells (106_0, 108_0, 106_N, 108_N) coupled to a plurality of first complementary bit line pairs (BL[0], BLB[0], BL[1], BLB[1]), respectively. The first multiplexer circuit (110) is coupled between the first complementary bit line pairs (BL[0], BLB[0], BL[1], BLB[1]) and a complementary data line pair (DL, DLB). The pre-charge circuit (112) is configured to pre-charge the complementary data line pair (DL, DLB), and is further configured to pre-charge at least one of the first complementary bit line pairs (BL[0], BLB[0], BL[1], BLB[1]) through the first multiplexer circuit (110).

## Description

### Field of the Invention

The present invention relates to a memory design, and more particularly, to a static random access memory (SRAM) device with a pre-charge circuit shared between data lines (DLs) and bit lines (BLs).

### Background of the Invention

For a variety of system on a chip (SoC) applications, a cache storage element can be used to temporarily retain data for further processing. The conventional approach for this cache storage element is using SRAM bit-cells. Each of BLs and DLs needs to be pre-charged to a reference voltage after a read/write (R/W) operation. In a conventional SRAM peripheral circuit design, BLs are pre-charged by dedicated local pre-charge circuits, resulting in high area overhead. Furthermore, high peak current during the BL pre-charge period may induce electro-migration and IR drop issues. To pursue better performance, memory density becomes larger, which makes the SRAM area occupy a big portion of the total chip area. However, it is difficult to shrink SRAM bit-cells in advanced semiconductor process technology. Thus, there is a need for an innovative SRAM peripheral circuit design which can have smaller pre-charge circuit area and/or lower pre-charge peak current.

### Summary of the Invention

This in mind, the present invention aims at providing an SRAM device with a pre-charge circuit shared between DLs and BLs to achieve smaller pre-charge circuit area and/or lower pre-charge peak current.

This is achieved by an SRAM device according to the independent claim. The dependent claims pertain to corresponding further developments and improvements.

As will be seen more clearly from the detailed description following below, the claimed memory device includes a first SRAM array, a first multiplexer circuit, and a pre-charge circuit. The first SRAM array includes a plurality of first SRAM cells coupled to a plurality of first complementary BL pairs, respectively. The first multiplexer circuit is coupled between the plurality of first complementary BL pairs and a complementary DL pair. The pre-charge circuit is configured to pre-charge the complementary DL pair, and is further configured to pre-charge at least one of the plurality of first complementary BL pairs through the first multiplexer circuit.

### Brief Description of the Drawings

In the following, the invention is further illustrated by way of example, taking reference to the accompanying drawings. Thereof
FIG. 1 is a diagram illustrating a first memory design according to an embodiment of the present invention,
FIG. 2 is a diagram illustrating waveforms of signals in a memory device shown in FIG. 1,
FIG. 3 is a diagram illustrating a floorplan comparison between a conventional memory design and a proposed memory design,
FIG. 4 is a diagram illustrating a second memory design according to an embodiment of the present invention,
FIG. 5 is a diagram illustrating waveforms of signals in a memory device shown in FIG. 4,
FIG. 6 is a diagram illustrating a DL pre-charge circuit with an adjustable pre-charge strength according to an embodiment of the present invention, and
FIG. 7 is a diagram illustrating different use cases of the DL pre-charge circuit shown in FIG. 6.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

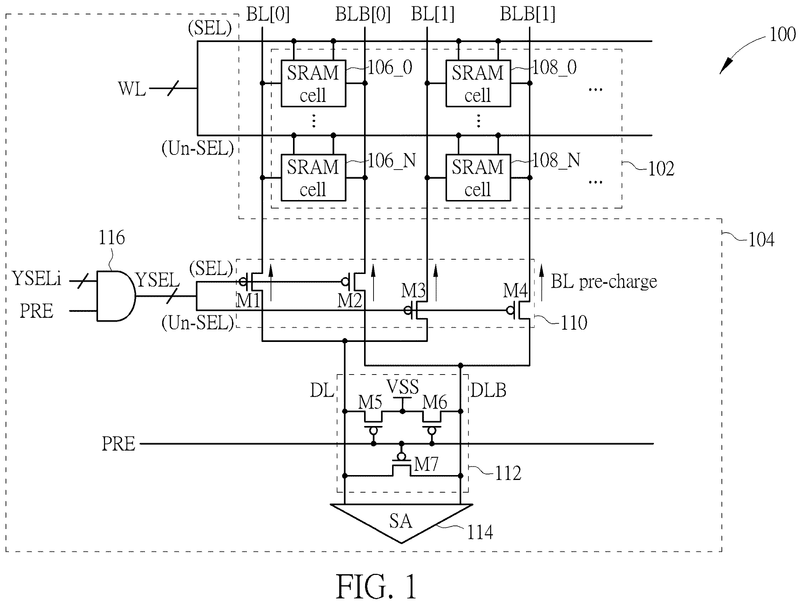

FIG. 1 is a diagram illustrating a first memory design according to an embodiment of the present invention. For example, the memory device 100 is an SRAM device that may be used as an SRAM cache in an SoC design. As shown in FIG. 1, the memory device 100 includes an SRAM array 102 and a peripheral circuit 104. The SRAM array 102 includes a plurality of SRAM cells (also called SRAM bit-cells) arranged in a two-dimensional (2D) array with a plurality of rows and a plurality of columns. As shown in FIG. 1, the 1^{st} SRAM cell column may include N+1 SRAM cells 106_0-106_N, and the 2^{nd} SRAM cell column may include N+1 SRAM cells 108_0-108_N, where SRAM cells 106_0 and 108_0 are located at the 1^{st} SRAM cell row, and the SRAM cells 106_N and 108_N are located at the (N+1)^{th} SRAM cell row. It should be noted that the SRAM array 102 may include more than four SRAM cells, more than two SRAM cell columns, and more than two SRAM cell rows. For brevity and simplicity, only four SRAM cells 106_0, 106_N, 108_0, 108_N are illustrated in FIG. 1. Each of the SRAM cells 106_0, 106_N, 108_0, 108_N is coupled to a complementary BL pair. For example, each of the SRAM cells 106_0 and 106_N located at the 1^{st} SRAM cell column is coupled to a complementary BL pair (BL[0], BLB[0]), and each of the SRAM cells 108_0 and 108_N located at the 2^{nd} SRAM cell column is coupled to a complementary BL pair (BL[1], BLB[1]).

The peripheral circuit 104 acts as an input/output (I/O) circuit used to control access (read/write) of the SRAM array 102. For example, the peripheral circuit 104 may include a row decoder, a timing controller, a column decoder, a sense amplifier, etc. As shown in FIG. 1, a multiplexer circuit 110 of the peripheral circuit 104 serves as a BL multiplexer coupled between a plurality of complementary BL pairs (e.g., (BL[0], BLB[0]) and (BL[1], BLB[1])) and one complementary DL pair (DL, DLB), where the complementary DL pair (DL, DLB) is coupled to a sense amplifier (SA) 114. The multiplexer circuit 110 includes a plurality of transistors acting as YPASS gates. For example, the transistor M1 is coupled between BL[0] and DL, the transistor M2 is coupled between BLB[0] and DLB, the transistor M3 is coupled between BL[1] and DL, and the transistor M4 is coupled between BLB[1] and DLB. In this embodiment, each of the transistors M1-M4 is implemented using a P-channel metal-oxide-semiconductor (PMOS) transistor, and has a gate voltage controlled by a column selection signal YSEL.

For example, when the 1^{st} SRAM cell column is selected by a column decoder during a period of a read/write (R/W) mode of the SRAM array 102, the selected transistors M1 and M2 included in the multiplexer circuit 110 are turned on by YSEL(SEL)=0V, and all un-selected transistors (e.g., M3 and M4) included in the multiplexer circuit 110 are turned off by YSEL(Un-SEL)=VCC, as illustrated in FIG. 1. If the 1^{st} word line (WL) is selected by a row decoder, the SRAM cell 106_0 is accessed by an R/W operation. If the (N+1)^{th} WL is selected by the row decoder, the SRAM cell 106_N is accessed by an R/W operation.

For another example, when the 2^{nd} SRAM cell column is selected by the column decoder during the period of the R/W mode of the SRAM array 102, the selected transistors M3 and M4 included in the multiplexer circuit 110 are turned on by YSEL(SEL)=0V, and all un-selected transistors (e.g., M1 and M2) included in the multiplexer circuit 110 are turned off by YSEL(Un-SEL)=VCC. If the 1^{st} WL is selected by the row decoder, the SRAM cell 108_0 is accessed by an R/W operation. If the (N+1)^{th} WL is selected by the row decoder, the SRAM cell 108_N is accessed by an R/W operation.

The peripheral circuit 104 further includes a DL pre-charge circuit 112 that is a global pre-charge circuit configured to pre-charge the complementary DL pair (DL, DLB). In this embodiment, the column selection signal YSEL is properly controlled to enable the proposed hardware sharing scheme of the DL pre-charge circuit 112. Specifically, a control logic 116 is added to perform a logic operation upon an original column selection signal YSELi (which is an output of a column decoder) and a pre-charge control signal PRE to control the final column selection signal YSEL applied to the multiplexer circuit 110.

As shown in FIG. 1, the DL pre-charge circuit 112 may include a plurality of transistors (e.g., PMOS transistors) M5, M6, M7 controlled by the pre-charge control signal PRE, where the transistor M5 pre-charges DL to a reference voltage (e.g., supply voltage VCC) when turned on, the transistor M6 pre-charges DLB to the reference voltage (e.g., supply voltage VCC) when turned on, and the transistor M7 acts as an equalizer between DL and DLB when turned on. It should be noted that the present invention has no limitations on the actual implementation of the DL pre-charge circuit 112. In practice, any pre-charge circuit design may be adopted by the DL pre-charge circuit 112.

In this embodiment, the memory device 100 has no dedicated BL pre-charge circuit (which is a local pre-charge circuit) used to pre-charge a corresponding complementary BL pair, and reuses YPASS gates (e.g., M1-M4) of the multiplexer circuit 110 as BL pre-charge circuits of the complementary BL pairs. Specifically, there is no dedicated BL pre-charge circuit connected between bit lines of each complementary BL pair. The multiplexer circuit 110 is used to connect one of the complementary BL pairs to the complementary DL pair (DL, DLB) during a period P1 of an R/W mode of the SRAM array 102 (i.e., OP = R/W), and is reused as a BL pre-charge circuit of at least a portion (i.e., part or all) of the complementary BL pairs during a period P2 of a pre-charge mode of the SRAM array 102 (i.e., OP = BL/DL pre-charge), where an R/W operation of the SRAM array 102 is followed by a BL/DL pre-charge operation. Specifically, during the period P2 of the pre-charge mode of the SRAM array 102, the multiplexer circuit 110 connects each of the complementary BL pairs to the complementary DL pair (DL, DLB), thereby enabling a pre-charge path between each complementary BL pair and the DL pre-charge circuit 112. In other words, the DL pre-charge circuit 112 is configured to pre-charge the complementary DL pair (DL, DLB), and is further configured to pre-charge at least a portion (i.e., part or all) of the complementary BL pairs through the multiplexer circuit 110. When the multiplexer circuit 110 connects each of the complementary BL pairs to the complementary DL pair (DL, DLB) during the period P2 of the pre-charge mode of the SRAM array 102, the DL pre-charge circuit 112 is also shared between the complementary BL pairs after enabled by the pre-charge control signal PRE. The same objective of pre-charging the complementary BL pairs to a reference voltage (e.g., supply voltage VCC) can be achieved with the aid of the DL pre-charge circuit 112 (which is controlled by PRE) and the multiplexer circuit 110 (which is controlled by YSEL).

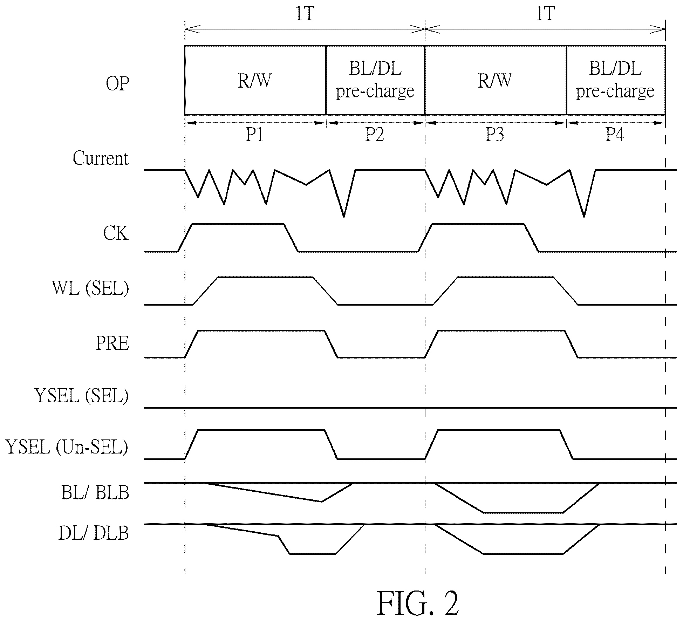

Please refer to FIG. 2 in conjunction with FIG. 1. FIG. 2 is a diagram illustrating waveforms of signals in the memory device 100 shown in FIG. 1. One clock cycle of a memory clock CK is 1T. During the period P1 of the R/W mode of the SRAM array 102, the 1^{st} WL is selected by WL(SEL)=VCC, the DL pre-charge circuit 112 is disabled by PRE=VCC, the complementary BL pair (BL[0], BLB[0]) is selected by YSEL(SEL)=0V, the complementary BL pair (BL[1], and BLB[1]) is unselected by YSEL(Un-SEL)=VCC. Hence, an R/W operation is performed upon the selected SRAM cell 106_0 in the SRAM array 102. During the period P2 of the pre-charge mode of the SRAM array 102, the 1^{st} WL is unselected by WL(SEL)=0V, the DL pre-charge circuit 112 is enabled by PRE=0V, the complementary BL pair (BL[0], BLB[0]) remains selected by YSEL(SEL)=0V, the complementary BL pair (BL[1], and BLB[1]) is selected by YSEL(Un-SEL)=0V. Hence, transistors (e.g., PMOS transistors) M1-M4 are all turned on to enable BL pre-charge paths between the complementary BL pairs (BL[0], BLB[0]), (BL[1], BLB[1]) and the DL pre-charge circuit 112. Since transistors (e.g., PMOS transistors) M5-M7 of the DL pre-charge circuit 112 are turned on, the DL pre-charge circuit 112 pre-charges the complementary DL pair (DL, DLB) to the reference voltage (e.g., supply voltage VCC). Since the complementary DL pair (DL, DLB) is connected to the complementary BL pairs (BL[0], BLB[0]), (BL[1], BLB[1]) through the turned-on transistors (e.g., PMOS transistors) M1-M4, pre-charging of the complementary DL pair (DL, DLB) also pre-charges the complementary BL pairs (BL[0], BLB[0]), (BL[1], BLB[1]). Hence, with the aid of the transistors M1-M4 reused as BL pre-charge circuits for enabling BL pre-charge paths between the DL pre-charge circuit 112 and the complementary BL pairs, the complementary BL pairs can be pre-charged in the absence of dedicated BL circuits. In this way, the area can be saved by reusing transistors of the multiplexer circuit 110 and sharing the DL pre-charge circuit 112 between DLs and BLs.

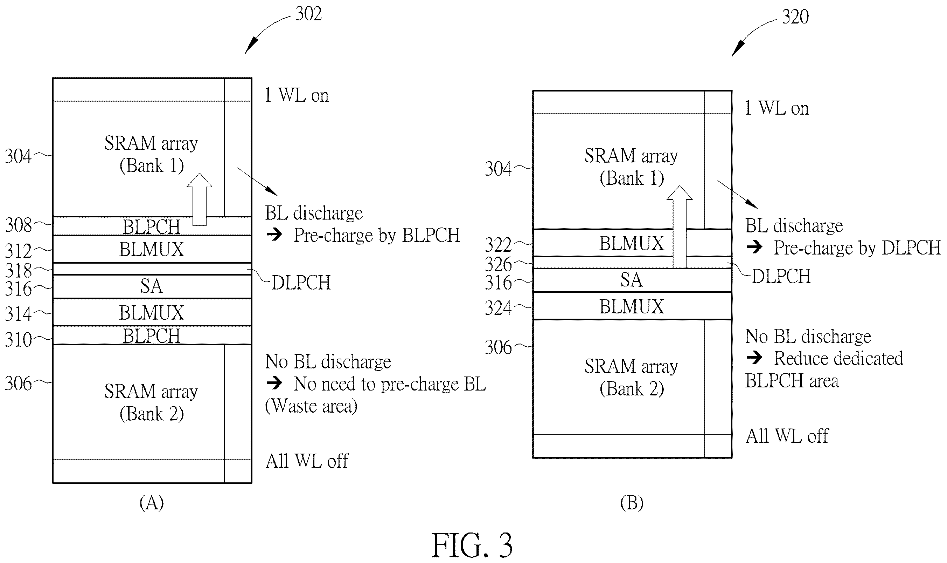

In some embodiments of the present invention, different banks may share one pre-charge circuit (particularly, one DL pre-charge circuit) to save area. FIG. 3 is a diagram illustrating a floorplan comparison between a conventional memory design and a proposed memory design. The sub-diagram (A) of FIG. 3 shows a floorplan of a conventional memory design 302 without pre-charge hardware sharing. The conventional memory device 302 includes two SRAM arrays 304, 306, where the SRAM array 304 serves as a first bank (labeled by "Bank 1"), and the SRAM array 306 serves as a second bank (labeled by "Bank 2"). The conventional memory device 302 has dedicated BL pre-charge circuits (labeled by "BLPCH") 308 for pre-charging complementary BL pairs connected to SRAM cells of the SRAM array 304, and has dedicated BL pre-charge circuits (labeled by "BLPCH") 310 for pre-charging complementary BL pairs connected to SRAM cells of the SRAM array 306. One multiplexer circuit (labeled by "BLMUX") 312 connects one of complementary BL pairs of the SRAM array 304 to a complementary DL pair during an R/W operation of a selected SRAM cell, where the complementary DL pair is connected to a sense amplifier (labeled by "SA") 316. Another multiplexer circuit (labeled by "BLMUX") 314 connects one of complementary BL pairs of the SRAM array 306 to the complementary DL pair during an R/W operation of a selected SRAM cell. In addition, one DL pre-charge circuit (labeled by "DLPCH") 318 is used to pre-charge the complementary DL pair. In most cases, only one of the SRAM arrays 304, 306 is accessed at a time. For example, after the R/W operation of the SRAM array 304 is done, a BL pre-charge operation of the SRAM array 304 should be initiated. However, since there is no R/W operation of the other SRAM array 304, the dedicated BL pre-charge circuits (labeled by "BLPCH") 310 are idle at this moment, resulting in waste of the area.

The sub-diagram (B) of FIG. 3 shows a floorplan of a proposed memory design 320 with pre-charge hardware sharing. To address the above-mentioned area issue, the present invention proposes omitting dedicated BL pre-charge circuits and sharing the same DL pre-charge circuit (labeled by "DLPCH") 326 between different SRAM arrays (i.e., different banks) 304 and 306 through multiplexer circuits (labeled by "BLMUX") 322, 324. Since only one bank WL is on, only one bank BL is discharged and needs to be pre-charged. Different banks can share one DL pre-charge circuit (labeled by "DLPCH") 326 if only one bank WL is on.

Each of the SRAM arrays 304 and 306 may be implemented using the SRAM array 102 shown in FIG. 1. Each of the multiplexer circuits (labeled by "BLMUX") 322 and 324 may be implemented using the multiplexer circuit 110 shown in FIG. 1. The DL pre-charge circuit (labeled by "DLPCH") 326 may be implemented using the DL pre-charge circuit 112 shown in FIG. 1. The sense amplifier 316 may be implemented using the sense amplifier 114 shown in FIG. 1.

Consider a case where the SRAM array 102 shown in FIG. 1 is the SRAM array (Bank 1) 304 shown in FIG. 3, the multiplexer circuit 110 shown in FIG. 1 is the multiplexer circuit (labeled by "BLMUX") 322 shown in FIG. 3, and the DL pre-charge circuit 112 is the DL pre-charge circuit (labeled by "DLPCH") 326 shown in FIG. 3. The SRAM array (Bank 1) 304 may perform an R/W operation during the period P1 shown in FIG. 2 and a pre-charge operation during the period P2 shown in FIG. 2. During the period P1 of the R/W mode of the SRAM array (Bank 1) 304, the multiplexer circuit (labeled by "BLMUX") 322 connects a selected complementary BL pair (BL[0], BLB[0]) to the complementary DL pair (DL, DLB), and the DL pre-charge circuit (labeled by "DLPCH") 326 is disabled. During the period P2 of the pre-charge mode of the SRAM array (Bank 1) 304, the multiplexer circuit (labeled by "BLMUX") 322 connects all complementary BL pairs (which include (BL[0], BLB[0]) and (BL[1], BLB[1])) to the complementary DL pair (DL, DLB), and the DL pre-charge circuit (labeled by "DLPCH") 326 is enabled to pre-charge the complementary DL pair (DL, DLB) and to pre-charge all complementary BL pairs (which include (BL[0], BLB[0]) and (BL[1], BLB[1])) through the multiplexer circuit (labeled by "BLMUX") 322.

Consider another case where the SRAM array 102 shown in FIG. 1 is the SRAM array (Bank 2) 306 shown in FIG. 3, the multiplexer circuit 110 shown in FIG. 1 is the multiplexer circuit (labeled by "BLMUX") 324 shown in FIG. 3, and the DL pre-charge circuit 112 is the DL pre-charge circuit (labeled by "DLPCH") 326 shown in FIG. 3. The SRAM array (Bank 1) 304 and the SRAM array (Bank 2) 306 are selected in different clock cycles of the memory clock CK. The SRAM array (Bank 2) 306 may perform an R/W operation during a period P3 shown in FIG. 2 and a pre-charge operation during a period P4 shown in FIG. 2. During the period P3 of an R/W mode of the SRAM array (Bank 2) 306, the multiplexer circuit (labeled by "BLMUX") 324 connects a selected complementary BL pair (BL[0], BLB[0]) to the complementary DL pair (DL, DLB), and the DL pre-charge circuit (labeled by "DLPCH") 326 is disabled. During the period P4 of a pre-charge mode of the SRAM array (Bank 2) 306, the multiplexer circuit (labeled by "BLMUX") 324 connects all complementary BL pairs (which include (BL[0], BLB[0]) and (BL[1], BLB[1])) to the complementary DL pair (DL, DLB), and the DL pre-charge circuit (labeled by "DLPCH") 326 is enabled to pre-charge the complementary DL pair (DL, DLB) and to pre-charge all complementary BL pairs (which include (BL[0], BLB[0]) and (BL[1], BLB[1])) through the multiplexer circuit (labeled by "BLMUX") 324. It should be noted that the period P2 of the pre-charge mode of the SRAM array (Bank 1) 304 does not overlap the period P4 of the pre-charge mode of the SRAM array (Bank 2) 306, thus allowing different banks to share the same DL pre-charge circuit.

Regarding the memory design shown in FIG. 1, the DL pre-charge circuit 112 is enabled at the time the transistors of the multiplexer circuit 110 are turned on to enable BL pre-charge paths between complementary BL pairs and DL pre-charge circuit 112. However, an initial voltage difference between two bit lines of the same complementary BL pair at the time the complementary BL pair is pre-charged by the DL pre-charge circuit 112 is large, causing high peak current. To address this peak current issue, the present invention proposes turning on transistors of the multiplexer circuit 110 before the DL pre-charge circuit 112 is enabled. In other words, charge sharing among BLs is enabled before the BL/DL pre-charge starts.

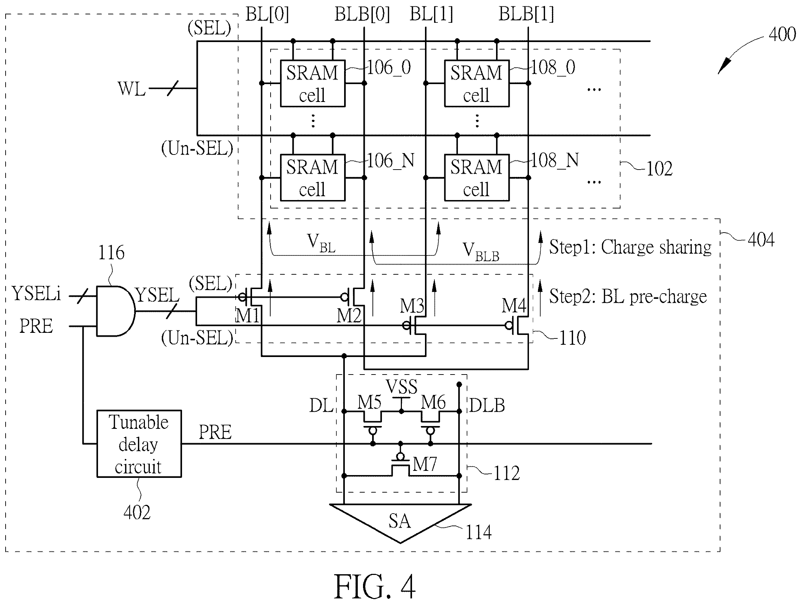

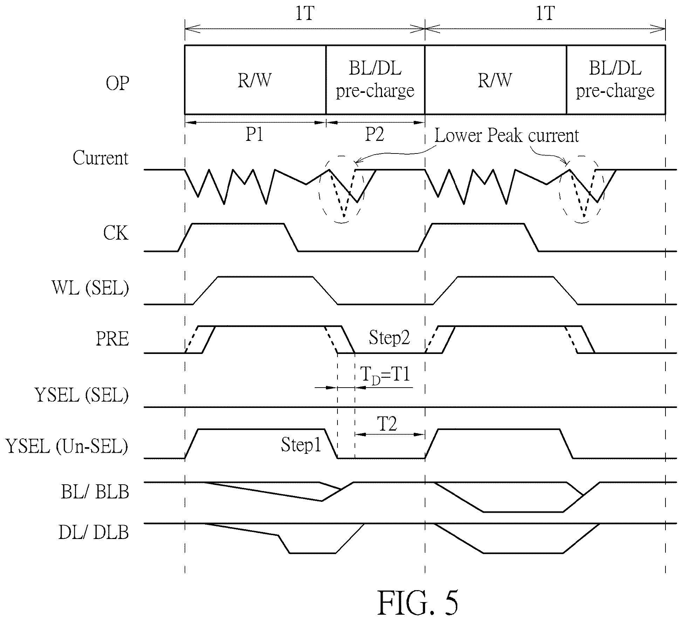

Please refer to FIG. 4 in conjunction with FIG. 5. FIG. 4 is a diagram illustrating a second memory design according to an embodiment of the present invention. FIG. 5 is a diagram illustrating waveforms of signals in the memory device 400 shown in FIG. 4. For example, the memory device 400 is an SRAM device that may be used as an SRAM cache in an SoC design. The major difference between two memory designs shown in FIG. 1 and FIG. 4 is that the peripheral circuit 404 of the memory device 400 further incudes a tunable delay circuit 402 configured to set a tunable delay time T_{D} which delays the timing of enabling the DL pre-charge circuit 112. Specifically, the pre-charge control signal PRE is received by the DL pre-charge circuit 112 after being delayed by the tunable delay circuit 402 (particularly, tunable delay time T_{D} set by tunable delay circuit 402). In addition, the charge sharing time is controlled by the tunable delay time T_{D} set by the tunable delay circuit 402.

The pre-charge mode of the SRAM array 102 includes a charge sharing phase (step 1) and a BL pre-charge phase (step 2). The tunable delay circuit 402 outputs a delayed version of the pre-charge control signal PRE to the DL pre-charge circuit 112, and therefore controls a start time of the BL pre-charge phase. During a period T1 (T1 = T_{D}) of the charge sharing phase, the multiplexer circuit 110 connects at least a portion (i.e., part or all) of the complementary BL pairs to the complementary DL pair (DL, DLB) under a condition that the DL pre-charge circuit 112 is disabled. The voltage difference between two bit lines of any complementary BL pair can be reduced due to charge sharing. Specifically, charge sharing occurs among DL, BL[0] and BL[1] shown in FIG. 4, and charge sharing among DLB, BLB[0] and BLB[1] shown in FIG. 4. For example, a voltage V_{BL}/V_{BLB} at each bit line may approach ~60% VSS due to charge sharing.

During a period T2 of the BL pre-charge phase, the multiplexer circuit 110 keeps connecting at least a portion (i.e., part or all) of the complementary BL pairs to the complementary DL pair (DL, DLB), and the DL pre-charge circuit 112 is enabled to pre-charge the complementary DL pair as well as the complementary BL pairs. Since the voltage V_{BL}/V_{BLB} at each bit line may approach ~60% VSS before the DL pre-charge circuit 112 is enabled. When the DL pre-charge circuit 112 is enabled, it only needs to pre-charge the complementary BL pairs from V_{BL}/V_{BLB} (e.g., ~60% VSS) to a reference voltage (e.g., supply voltage VSS), resulting in lower peak current.

As mentioned above, the DL pre-charge circuit 112 used for pre-charging the complementary DL pairs (DL, DLB) can be shared by complementary BL pairs through the multiplexer circuit 110 with transistors reused as BL pre-charge circuits (which enable BL pre-charge paths between complementary BL pairs and DL pre-charge circuit 112). Regarding the memory designs shown in FIG. 1 and FIG. 4, the DL pre-charge circuit 112 is configured to provide a constant pre-charge strength. However, this is for illustrative purposes only, and is not meant to be a limitation of the present invention. In some embodiments of the present invention, the memory designs shown in FIG. 1 and FIG. 4 may be modified to have the DL pre-charge circuit 112 with a constant pre-charge strength replaced by a DL pre-charge circuit with an adjustable pre-charge strength.

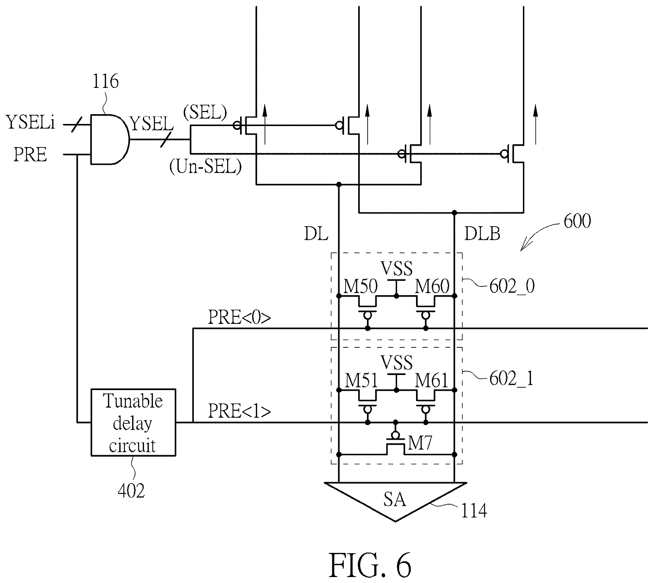

FIG. 6 is a diagram illustrating a DL pre-charge circuit with an adjustable pre-charge strength according to an embodiment of the present invention. In this embodiment, the DL pre-charge circuit 600 includes a plurality of pre-charge sub-circuits configured to apply different pre-charge strengths, respectively. For example, the DL pre-charge circuit 600 has two pre-charge sub-circuits 602_0 and 602_1, where a pre-charge strength of the pre-charge sub-circuit 602_1 is higher than a pre-charge strength of the pre-charge sub-circuit 602_0. For example, the pre-charge sub-circuit 602_0 may include transistors (e.g., PMOS transistors) M50 and M60 with smaller transistor sizes, and the pre-charge sub-circuit 602_1 may include transistors (e.g., PMOS transistors) M51, M61, M7 with larger transistor sizes.

In this embodiment, the pre-charge control signal PRE includes multiple pre-charge control signals PRE<0> and PRE<1> used to control pre-charge sub-circuits 602_0 and 602_1, respectively. When the DL pre-charge circuit 600 operates in a PCH_1X mode (which is a weaker per-charge (PCH) mode), the pre-charge sub-circuit 602_0 is enabled by the pre-charge control signal PRE<0>=0V, and a 1X pre-charge strength (e.g., 1X pre-charge current) is provided by the pre-charge sub-circuit 602_0. When the DL pre-charge circuit 600 operates in a PCH_2X mode (which is a stronger PCH mode), the pre-charge sub-circuit 602_1 is enabled by the pre-charge control signal PRE<1>=0V, and a 2X pre-charge strength (e.g., 2X pre-charge current) is provided by the pre-charge sub-circuit 602_1. During a period of an R/W mode of an SRAM array, the pre-charge sub-circuit 602_0 is disabled by the pre-charge control signal PRE<0>=VCC, and the pre-charge sub-circuit 602_1 is also disabled by the pre-charge control signal PRE<1>=VCC. Settings of the pre-charge control signals PRE<0> and PRE<1> under different operation modes are listed in the following table.

**Table 1**

| Mode | PRE<0> | PRE<1> | Pre-charge strength |
|---|---|---|---|
| R/W | VCC | VCC | 0X |
| PCH_1X | 0 | VCC | 1X |
| PCH_2X | VCC | 0 | 2X |

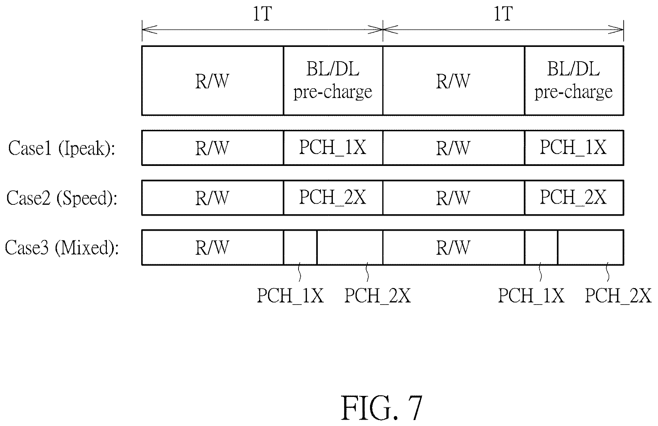

At least one of the pre-charge sub-circuits 602_0 and 602_1 is enabled during a period of a pre-charge mode of the SRAM array. Specifically, the adjustable BL pre-charge strength can optimize pre-charge speed and/or peak current, depending upon actual application considerations. FIG. 7 is a diagram illustrating different use cases of the proposed DL pre-charge circuit 600 with an adjustable pre-charge strength. As far as the peak current is concerned, the pre-charge sub-circuit 602_0 with a weaker pre-charge strength may be enabled, and the pre-charge sub-circuit 602_1 with a stronger pre-charge strength may be disabled. As far as the pre-charge speed is concerned, the pre-charge sub-circuit 602_0 with a weaker pre-charge strength may be disabled, and the pre-charge sub-circuit 602_1 with a stronger pre-charge strength may be enabled. As far as the peak current and the pre-charge speed are concerned, the pre-charge sub-circuit 602_0 with a weaker pre-charge strength and the pre-charge sub-circuit 602_1 with a stronger pre-charge strength may be enabled sequentially. For example, the pre-charge sub-circuit 602_0 is first enabled to optimize the peak current, and then the pre-charge sub-circuit 602_1 is enabled to optimize the pre-charge speed. However, these are for illustrative purposes only, and are not meant to be limitations of the present invention. In practice, any SRAM device sharing a pre-charge circuit with an adjustable pre-charge strength between DLs and BLs falls within the scope of the present invention.

## Claims

1. A memory device (100, 320, 400) **characterized by**:
a first static random access memory, SRAM, array (102, 304), comprising a plurality of first SRAM cells (106_0, 108_0, 106_N, 108_N) coupled to a plurality of first complementary bit line, BL, pairs (BL[0], BLB[0], BL[1], BLB[1]), respectively;
a first multiplexer circuit (110, 322), coupled between the plurality of first complementary BL pairs (BL[0], BLB[0], BL[1], BLB[1]) and a complementary data line, DL, pair (DL, DLB); and
a pre-charge circuit (112, 326, 600), configured to pre-charge the complementary DL pair (DL, DLB), and further configured to pre-charge at least one of the plurality of first complementary BL pairs (BL[0], BLB[0], BL[1], BLB[1]) through the first multiplexer circuit (112, 326, 600).

2. The memory device (100, 320, 400) of claim 1, **characterized in that** during a period of a pre-charge mode of the first SRAM array (102, 304), the first multiplexer circuit (112, 326, 600) connects each of the plurality of first complementary BL pairs (BL[0], BLB[0], BL[1], BLB[1]) to the complementary DL pair (DL, DLB).

3. The memory device (320) of claim 1, **characterized in that** the memory device (320) further comprises:
a second SRAM array (306), comprising a plurality of second SRAM cells coupled to a plurality of second complementary BL pairs, respectively; and
a second multiplexer circuit (324), coupled between the plurality of second complementary BL pairs and the complementary DL pair;
wherein the pre-charge circuit (326) is further configured to pre-charge at least one of the plurality of second complementary BL pairs through the second multiplexer circuit (324).

4. The memory device (320) of claim 3, **characterized in that** during a period of a pre-charge mode of the first SRAM array (304), the first multiplexer circuit (322) is configured to connect the at least one of the plurality of first complementary BL pairs (BL[0], BLB[0], BL[1], BLB[1]) to the complementary DL pair (DL, DLB); and during a period of a pre-charge mode of the second SRAM array (306) that does not overlap the period of the pre-charge mode of the first SRAM array (304), the second multiplexer circuit (324) is configured to connect the at least one of the plurality of second complementary BL pairs to the complementary DL pair.

5. The memory device (400) of claim 1, **characterized in that** a pre-charge mode of the first SRAM array (102) comprises a first phase and a second phase following the first phase; during a period (T1) of the first phase, the first multiplexer circuit (110) connects the at least one of the plurality of first complementary BL pairs (BL[0], BLB[0], BL[1], BLB[1]) to the complementary DL pair (DL, DLB), and the pre-charge circuit (112) is disabled; and during a period (T2) of the second phase, the first multiplexer circuit (110) keeps connecting the at least one of the plurality of first complementary BL pairs (BL[0], BLB[0], BL[1], BLB[1]) to the complementary DL pair (DL, DLB), and the pre-charge circuit (112) is enabled.

6. The memory device (400) of claim 5, **characterized in that** the memory device (400) further comprises:
a tunable delay circuit (402), configured to control a start time of the second phase.

7. The memory device (100, 320, 400) of claim 1, **characterized in that** the pre-charge circuit (600) comprises:
a plurality of pre-charge sub-circuits (602_0, 602_1), configured to apply different pre-charge strengths, respectively;
wherein at least one of the plurality of pre-charge sub-circuits (602_0, 602_1) is enabled during a period of a pre-charge mode of the first SRAM array (102, 304).

8. The memory device (100, 320, 400) of claim 7, **characterized in that** during the period of the pre-charge mode of the first SRAM array (102, 304), only one of the plurality of pre-charge sub-circuits (602_0, 602_1) is enabled.

9. The memory device (100, 320, 400) of claim 7, **characterized in that** during the period of the pre-charge mode of the first SRAM array (102, 304), at least two of the plurality of pre-charge sub-circuits (602_0, 602_1) are enabled sequentially.

10. The memory device (100, 320, 400) of claim 9, **characterized in that** the at least two of the plurality of pre-charge sub-circuits (602_0, 602_1) comprise a first pre-charge sub-circuit (602_0) and a second pre-charge sub-circuit (602_1), a pre-charge strength of the second pre-charge sub-circuit (602_1) is higher than a pre-charge strength of the first pre-charge sub-circuit (602_0), and the second pre-charge sub-circuit (602_1) is enabled later than the first pre-charge sub-circuit (602_0).

11. The memory device (100, 320, 400) of claim 1, **characterized in that** the first multiplexer circuit (110, 322) is used to connect one of the plurality of first complementary BL pairs (BL[0], BLB[0], BL[1], BLB[1]) to the complementary DL pair (DL, DLB) during a period of a read/write mode of the first SRAM array (102, 304), and is reused as a BL pre-charge circuit of at least one of the plurality of first complementary BL pairs (BL[0], BLB[0], BL[1], BLB[1]) during a period of a pre-charge mode of the first SRAM array (102, 304).

12. The memory device (100, 320, 400) of claim 11, **characterized in that** during the period of the pre-charge mode of the first SRAM array (102, 304), the first multiplexer circuit (110, 322) is used as a BL pre-charge circuit of each of the plurality of first complementary BL pairs (BL[0], BLB[0], BL[1], BLB[1]).

13. The memory device (320) of claim 11, **characterized in that** the memory device (320) further comprises:
a second SRAM array (306), comprising a plurality of second SRAM cells coupled to a plurality of second complementary BL pairs, respectively; and
a second multiplexer circuit (324), coupled between the plurality of second complementary BL pairs and the complementary DL pair, wherein the second multiplexer circuit (324) is used to connect one of the plurality of second complementary BL pairs to the complementary DL pair during a period of a read/write mode of the second SRAM array (306), and is reused as a BL pre-charge circuit of at least one of the plurality of second complementary BL pairs during a period of a pre-charge mode of the second SRAM array (306).

14. The memory device (320) of claim 13, **characterized in that** during the period of pre-charge mode of the first SRAM array (304), the first multiplexer circuit (322) is used as a BL pre-charge circuit of each of the plurality of first complementary BL pairs; and during the period of the pre-charge mode of the second SRAM array (306) that does not overlap the period of the pre-charge mode of the first SRAM array (304), the second multiplexer circuit (324) is used as a BL pre-charge circuit of each of the plurality of second complementary BL pairs.

15. The memory device (400) of claim 11, **characterized in that** the pre-charge mode of the first SRAM array (102) comprises a first phase and a second phase following the first phase; during a period (T1) of the first phase, the BL pre-charge circuit (110) is enabled, and the DL pre-charge circuit (112) is disabled; and during the period (T2) of the second phase, the BL pre-charge circuit (110) keeps enabled, and the DL pre-charge circuit (112) is enabled.
